# EUROPEAN PATENT APPLICATION

(11) **EP 4 838 240 A1**
(43) Date of publication of application: **11.11.2026**
(21) Application number: 24897195.4
(22) Date of filing: 31.10.2024
(51) Int. Cl.: G01R 31/3835, G01R 31/00, G01R 31/388, G01R 31/3842, H02J 7/00

(54) **BATTERY MANAGEMENT SYSTEM, MANAGEMENT DEVICE, CYCLE SETTING METHOD, AND PROGRAM**

(30) Priority: 30.11.2023 JP 2023203101
(71) Applicant: FDK Corporation, Tokyo 108-8212 (JP)
(72) Inventor: KATO, Yoshihiro, Tokyo 108-8212 (JP); KANEHIRA, Tomohiro, Tokyo 108-8212 (JP); HOSHINO, Masanori, Tokyo 108-8212 (JP)
(74) Representative: Tiburzi, Andrea
(86) International application number: PCT/JP2024/038829
(87) International publication number: WO 2025/115506

(57) **Abstract**

Provided are a battery management system, a management device, a cycle setting method, and a program capable of automatically setting a voltage measurement time even if the number of connected monitoring devices changes. The battery management system is provided with a plurality of monitoring devices that measure the voltage of each of a plurality of secondary batteries, and a management device that manages the plurality of monitoring devices, wherein the management device acquires, from each monitoring device, a voltage measurement time indicating the time required to measure the voltage of the corresponding secondary battery, and unifies the voltage measurement time of each monitoring device based on a plurality of the acquired voltage measurement times.

## Description

### Technical Field

The present disclosure relates to a battery management system, a management device, a cycle setting method, and a program.

### Background Art

Conventionally, battery management systems are known in which a plurality of monitoring devices serving as slave devices are connected to a single management device serving as a master device, with secondary batteries used as a power storage system (see, for example, Patent Literature (hereinafter, referred to as PTL) 1).

In a battery management system, a secondary battery is connected to each of a plurality of monitoring devices. Each monitoring device measures the voltage of its connected secondary battery and transmits the measurement result to the management device. The management device manages the monitoring devices and secondary batteries based on the measurement results received from the plurality of monitoring devices.

The management device also synchronizes the measurement cycles of the plurality of monitoring devices for the secondary batteries and sets a predetermined voltage measurement time for the monitoring devices. When the voltage measurement times differ among the monitoring devices, the voltage measurement time is set to match the longest voltage measurement time among them.

The voltage measurement time of a monitoring device depends on the measurement performance of the monitoring IC (Integrated Circuit) installed in that monitoring device. Accordingly, the voltage measurement time in a battery management system is set based on the measurement performance of the monitoring IC installed in each monitoring device.

### Citation List

### Patent Literature

PTL 1
Japanese Patent Application Laid-Open No. 2010-142040

### Summary of Invention

### Technical Problem

Incidentally, when the number of monitoring devices connected to the management device changes, the voltage measurement time is reconfigured taking into account both the number of connected devices and the measurement performance of the monitoring ICs in use. Since such a configuration of the voltage measurement time is typically performed manually by an operator, the operator is required to redesign the voltage measurement time for the monitoring devices.

Furthermore, when a monitoring device is added to the battery management system, the added monitoring device is not synchronized with the other monitoring devices, resulting in a discrepancy in the measurement timing of the secondary battery by the monitoring devices. The operator is therefore required to synchronize the added monitoring device with the other monitoring devices.

Moreover, even when the number of monitoring devices connected to the management device remains unchanged, replacing the monitoring IC installed in a monitoring device changes the voltage measurement time, which represents the measurement performance of that monitoring IC. In such a case, the voltage measurement time needs to be redesigned.

An object of the present disclosure is to provide a battery management system, a management device, a cycle setting method, and a program each capable of automatically setting the voltage measurement time even when the number of connected monitoring devices changes.

### Solution to Problem

A battery management system according to the present disclosure includes: a plurality of monitoring devices that each measure a voltage of corresponding one of a plurality of secondary batteries; and a management device that manages the plurality of monitoring devices, in which the management device acquires, from each of the plurality of monitoring devices, a voltage measurement time indicating a time required to measure the voltage of corresponding one of the plurality of secondary batteries, and the management device unifies the voltage measurement time of each of the plurality of monitoring devices based on a plurality of the acquired voltage measurement times.

Furthermore, a management device according to the present disclosure is a management device for managing a plurality of monitoring devices that each measure a voltage of corresponding one of a plurality of secondary batteries, and the management device includes: a processing unit that acquires, from each of the plurality of monitoring devices, a voltage measurement time indicating a time required for measuring the voltage of corresponding one of the plurality of secondary batteries, and unifies the voltage measurement time of each of the plurality of monitoring devices based on a plurality of the acquired voltage measurement times.

Moreover, a cycle setting method according to the present disclosure is a cycle setting method for a battery management system that includes: a plurality of secondary batteries; a plurality of monitoring devices each measuring a voltage of corresponding one of the plurality of secondary batteries; and a management device for managing the plurality of monitoring devices, and the cycle setting method includes: acquiring, from each of the plurality of monitoring devices, a voltage measurement time indicating a time required for measuring the voltage of corresponding one of the plurality of secondary batteries; and unifying the voltage measurement time of each of the plurality of monitoring devices based on a plurality of the acquired voltage measurement times.

In addition, a program according to the present disclosure causes a computer to execute the above- described cycle setting method.

### Advantageous Effects of Invention

According to the present disclosure, it is possible to automatically set the voltage measurement time even when the number of connected monitoring devices changes.

### Brief Description of Drawings

[FIG. 1] FIG. 1 is a schematic diagram illustrating an example of a configuration of a battery management system according to the present embodiment;
[FIG. 2] FIG. 2 is a schematic diagram for describing the setting of a voltage measurement time in a cycle setting process according to the present embodiment;
[FIG. 3] FIG. 3 is a schematic diagram for describing the setting of the voltage measurement time in the cycle setting process according to the present embodiment;
[FIG. 4] FIG. 4 is a schematic diagram for describing the setting of the voltage measurement time in the cycle setting process according to the present embodiment;
[FIG. 5] FIG. 5 is a schematic diagram for describing the setting of the voltage measurement time in the cycle setting process according to the present embodiment;
[FIG. 6] FIG. 6 is a sequence diagram illustrating an example of a flow of the cycle setting process by the battery management system according to the present embodiment;
[FIG. 7] FIG. 7 is a sequence diagram illustrating an example of a flow of the cycle setting process by the battery management system according to the present embodiment; and
[FIG. 8] FIG. 8 is a schematic diagram illustrating an example of a configuration of a battery management system according to a variation of the present embodiment.

### Description of Embodiments

Hereinafter, an embodiment of the present disclosure will be described with reference to the accompanying drawings. The present disclosure is not limited to the following embodiment, and may be modified in various ways without departing from the gist of the present disclosure. The present disclosure also encompasses all possible combinations of the configurations shown in the following embodiment that are capable of being combined. In addition, in the drawings, like reference numerals designate identical or corresponding elements throughout the specification.

### [Configuration of Battery Management System 1]

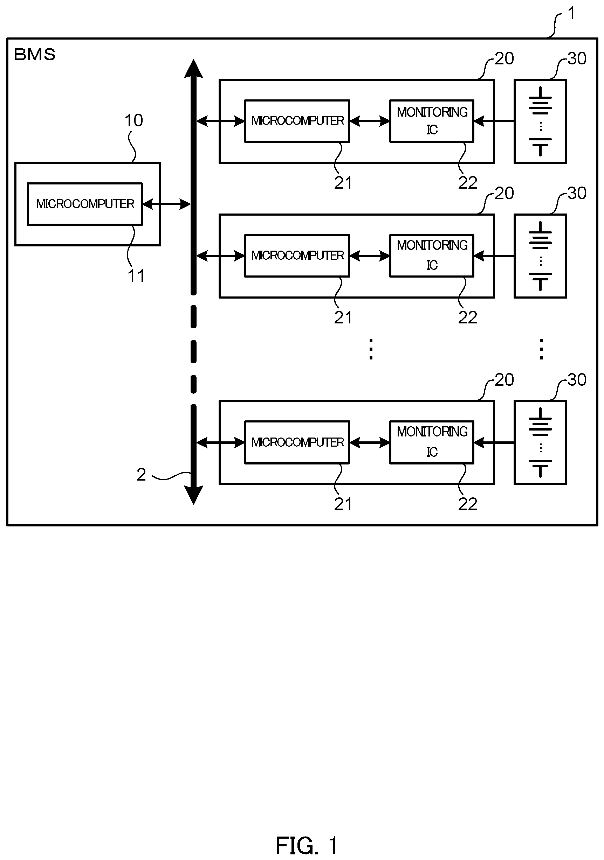

FIG. 1 is a schematic diagram illustrating an example of a configuration of battery management system 1 according to the present embodiment. Battery management system 1 (hereinafter, also referred to as "BMS" as appropriate) stores power supplied from an external power supply (not illustrated) and supplies the stored power to a power supply target (not illustrated). As illustrated in FIG. 1, BMS 1 includes management device 10, which is a master device, a plurality of monitoring devices 20, which are slave devices, and a plurality of secondary batteries 30. Management device 10 and the plurality of monitoring devices 20 are connected to bus 2.

### (Management Device 10)

Management device 10 controls and manages the plurality of monitoring devices 20 and the plurality of secondary batteries 30. Management device 10 communicates with each monitoring device 20 via bus 2 using a communication protocol such as a controller area network (CAN) to exchange instruction information and battery information.

Battery information is information related to secondary battery 30, such as a voltage of secondary battery 30. In addition, the instruction information is information for instructing monitoring device 20, including a request for a measurement value of the voltage in secondary battery 30 to monitoring device 20.

In the present embodiment, management device 10 transmits a voltage request to the plurality of monitoring devices 20 and sequentially receives a measurement result of the voltage of secondary battery 30 as battery information from each of the plurality of monitoring devices 20 within a preset master measurement time. The master measurement time is a required time for receiving the measurement results from all monitoring devices 20 connected to management device 10.

Management device 10 includes master-side microcomputer 11. Master-side microcomputer 11 includes a central processing unit (CPU), read only memory (ROM), random access memory (RAM), and the like (none of which are illustrated). The CPU reads a program corresponding to the processing content from the ROM, expands the program into the RAM, and exercises centralized control over the operation of management device 10 in cooperation with the expanded program. Master-side microcomputer 11 corresponds to a "processing unit" of the present disclosure.

In the present embodiment, master-side microcomputer 11 sets a voltage measurement time for monitoring devices 20. The voltage measurement time is a time required for measuring the voltage of secondary battery 30 in monitoring device 20. In the present embodiment, master-side microcomputer 11 sets a unified voltage measurement time for each of the plurality of monitoring devices 20 during a cycle setting process described later.

### (Monitoring Device 20)

Monitoring device 20 controls and monitors secondary battery 30. For example, monitoring device 20 monitors the voltage of secondary battery 30 based on detection results of various sensors (not illustrated). Monitoring device 20 includes slave-side microcomputer 21 and monitoring IC 22.

Slave-side microcomputer 21 includes a central processing unit (CPU), read only memory (ROM), random access memory (RAM), and the like (none of which are illustrated). The CPU reads a program corresponding to the processing content from the ROM, expands the program into the RAM, and exercises centralized control over the operation of power storage device 1 in cooperation with the expanded program.

In the present embodiment, slave-side microcomputer 21 transmits an instruction to monitoring IC 22 to measure the voltage and the like of secondary battery 30 connected to monitoring IC 22, based on a voltage acquisition cycle calculated in advance. Then, slave-side microcomputer 21 acquires battery information including the voltage of secondary battery 30 and the like from monitoring IC 22.

In addition, slave-side microcomputer 21 receives a voltage measurement time from master-side microcomputer 11 and sets the received voltage measurement time as a voltage measurement time of monitoring device 20.

Monitoring IC 22 monitors secondary battery 30 and acquires information related to secondary battery 30. For example, monitoring IC 22 measures a cell voltage, which is a voltage of each of a plurality of battery cells constituting secondary battery 30, as information related to secondary battery 30.

A predetermined voltage measurement time is specified in advance for monitoring IC 22. This voltage measurement time is, for example, a unique characteristic specified according to the type of monitoring IC 22. Therefore, the voltage measurement time in monitoring device 20 varies depending on the type of monitoring IC 22 in use. In addition, monitoring device 20 is configured to be incapable of measuring the voltage of secondary battery 30 in a shorter time than the voltage measurement time specified for monitoring IC 22.

### (Secondary Battery 30)

Secondary battery 30 is configured with one or a plurality of battery cells. When secondary battery 30 is configured with a plurality of battery cells, the battery cells are connected in series. Secondary battery 30 is, for example, a nickel-metal hydride secondary battery. Note that the type of secondary battery 30 is not limited to this example, and may be a secondary battery other than a nickel-metal hydride secondary battery, such as a lithium-ion secondary battery.

### [Measurement Cycle Setting Operation of BMS 1]

The measurement cycle setting operation in BMS 1 having the above configuration will be described. Conventionally, when measuring the cell voltage of secondary batteries 30 installed in BMS 1, the cell voltage of secondary batteries 30 is measured with the voltage measurement cycles of the plurality of monitoring devices 20 synchronized with one another.

The voltage measurement cycle, on the other hand, depends on the voltage measurement time, which is a characteristic of monitoring IC 22 installed in monitoring device 20. Accordingly, when synchronizing the plurality of monitoring devices 20, the voltage measurement time of monitoring IC 22 in each monitoring device 20 is set so as to be uniform. In such BMS 1, when the number of monitoring devices 20 or monitoring IC 22 installed in monitoring device 20 is changed, the voltage measurement times may no longer be uniform.

In view of this, in the present embodiment, a cycle setting process is performed to automatically set the voltage measurement time to a unified value based on the voltage measurement time of monitoring IC 22 of each monitoring device 20. The cycle setting process includes a slave synchronization process and a master measurement cycle setting process.

The slave synchronization process is a process of setting the voltage measurement time of each of the plurality of monitoring devices 20 serving as slave devices to a unified value, thereby synchronizing the plurality of monitoring devices 20. The master measurement cycle setting process is a process of setting a master measurement cycle, which indicates the cycle at which management device 10 serving as a master device acquires measurement values from all of monitoring devices 20.

### (Slave Synchronization Process)

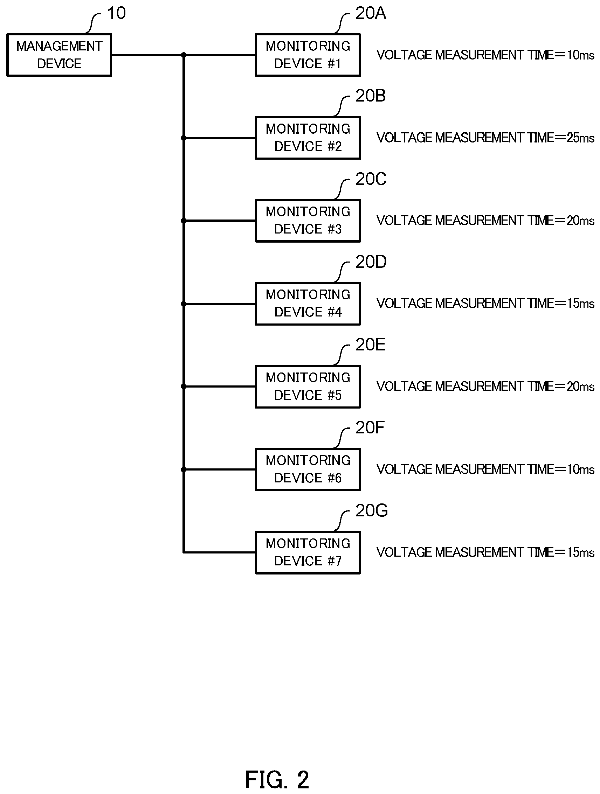

FIGS. 2 to 5 are schematic diagrams for describing the setting of the voltage measurement time in the cycle setting process according to the present embodiment. In the example shown in FIGS. 2 to 5, it is assumed that seven monitoring devices 20A to 20G are connected to management device 10.

In this example, the voltage measurement time is set as follows in each of monitoring devices 20A to 20G. As illustrated in FIG. 2, the voltage measurement time of monitoring IC 22 in monitoring device 20A (monitoring device #1) and monitoring device 20F (monitoring device #6) is "10 ms." The voltage measurement time of monitoring IC 22 in monitoring device 20B (monitoring device #2) is "25 ms." The voltage measurement time of monitoring IC 22 in monitoring device 20C (monitoring device #3) and monitoring device 20E (monitoring device #5) is "20 ms." The voltage measurement time of monitoring IC 22 in monitoring device 20D (monitoring device #4) and monitoring device 20G (monitoring device #7) is "15 ms."

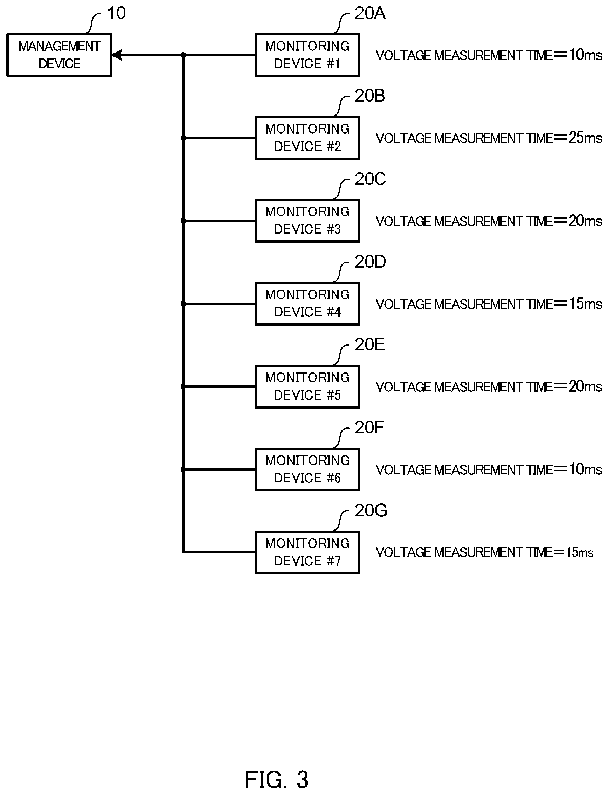

In the slave synchronization process, each of monitoring devices 20A to 20G first transmits the voltage measurement time to management device 10 in response to a voltage request from management device 10, as illustrated in FIG. 3. This allows management device 10 to acquire the voltage measurement time from each of monitoring devices 20A to 20G.

Next, upon acquiring the voltage measurement times from all of monitoring devices 20A to 20G, management device 10 sets the voltage measurement time so as to be uniform across monitoring devices 20A to 20G.

Here, when measuring the cell voltage of secondary battery 30, monitoring device 20 cannot measure the cell voltage in less time than the voltage measurement time specified for monitoring IC 22 installed therein. Therefore, the voltage measurement time to be unified across the plurality of monitoring devices 20A to 20G needs to be set to the longest voltage measurement time among those set in these monitoring devices 20A to 20G.

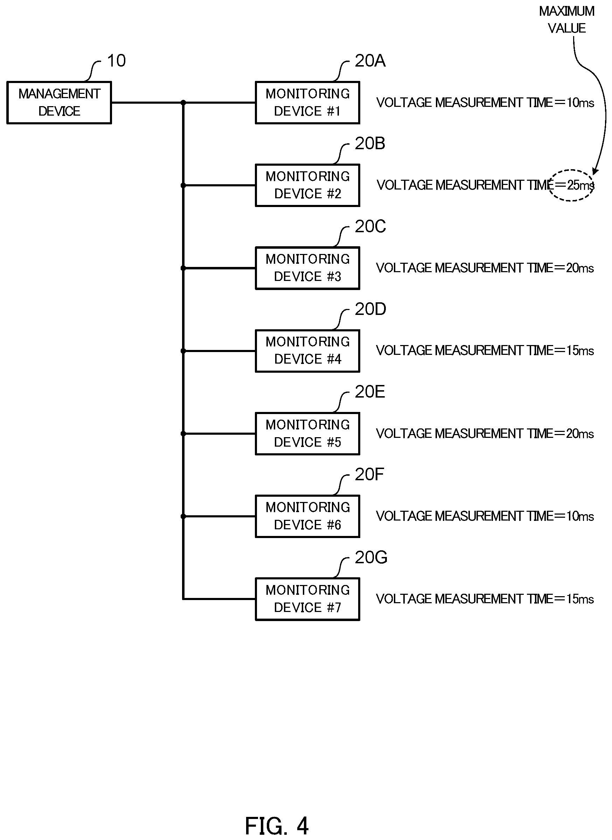

Accordingly, as illustrated in FIG. 4, management device 10 extracts the voltage measurement time having the maximum value from among the acquired voltage measurement times as the maximum voltage measurement time. In this example, since the voltage measurement time acquired from monitoring device 20B (25 ms) is the maximum, management device 10 extracts the voltage measurement time acquired from monitoring device 20B as the maximum voltage measurement time.

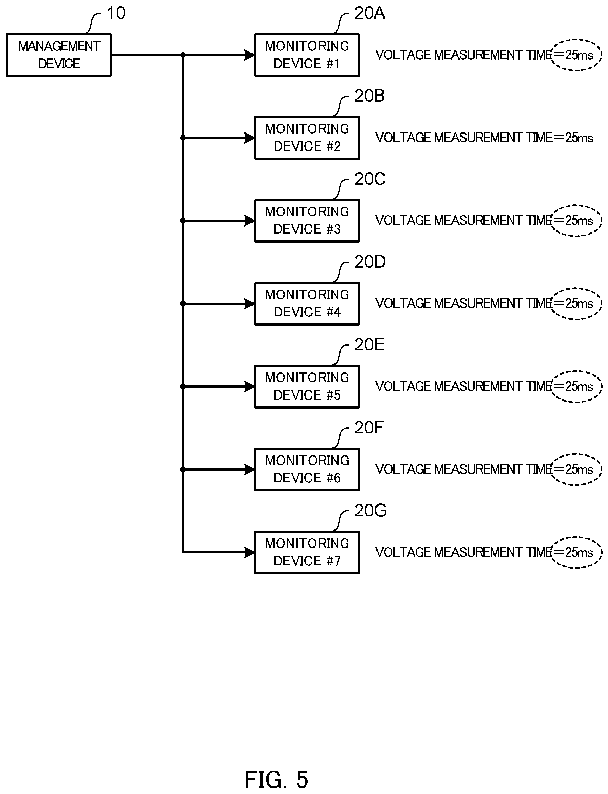

Next, as illustrated in FIG. 5, management device 10 notifies each of monitoring devices 20A to 20G of the extracted maximum voltage measurement time. Upon receiving the notification, each of monitoring devices 20A to 20G sets the received maximum voltage measurement time as its voltage measurement time.

In this manner, in the slave synchronization process, the voltage measurement time is automatically unified across all of monitoring devices 20A to 20G connected to management device 10. This allows the voltage measurement of secondary batteries 30 in monitoring devices 20A to 20G to be synchronized even when the number of monitoring devices 20 or monitoring IC 22 is changed.

### (Master Measurement Cycle Setting Process)

The master measurement cycle setting process is performed after the slave synchronization process is completed and management device 10 has received the cell voltage of secondary batteries 30 from all of monitoring devices 20A to 20G.

Upon receiving the measurement results from all of monitoring devices 20A to 20G, management device 10 confirms the number of connected monitoring devices 20. In this case, management device 10 confirms the number of connected monitoring devices 20 based on, for example, the number of monitoring devices 20 from which the voltage measurement time has been received during the slave synchronization process. In this example, since seven monitoring devices 20A to 20G are connected to management device 10 and a response is received from each of monitoring devices 20A to 20G, the number of connected devices is seven.

Upon confirming the number of connected monitoring devices 20, management device 10 calculates a voltage acquisition cycle of monitoring device 20. The voltage acquisition cycle is the cycle at which information indicating the voltage of secondary battery 30 is acquired from each monitoring device 20, and specifically includes a voltage measurement time and a voltage acquisition time. The voltage acquisition time is the time required for management device 10 to receive the cell voltage of secondary battery 30 from monitoring device 20. The voltage acquisition time is determined by the communication protocol and communication speed used between the management device and monitoring device 20.

Next, management device 10 calculates a master measurement cycle based on the number of connected monitoring devices 20 and the calculated voltage acquisition cycle. Specifically, management device 10 calculates the master measurement cycle by multiplying the calculated voltage acquisition cycle by the number of connected monitoring devices 20. This is because, when the number of cells of secondary battery 30 to be measured and the communication protocol and communication speed used for communication with management device 10 are common among monitoring devices 20A to 20G, the voltage acquisition time included in the voltage acquisition cycle can be treated as the same.

Note that management device 10 is not limited to this example, and may calculate the master measurement cycle by, for example, first calculating the voltage acquisition cycle for each of monitoring devices 20A to 20G and then accumulating the results. When the voltage acquisition time differs among monitoring devices 20A to 20G, calculating the master measurement cycle in this manner allows management device 10 to calculate the master measurement cycle more accurately.

Upon calculating the master measurement cycle, management device 10 compares the calculated master measurement cycle with the current set value (default value) of the preset master measurement cycle. When the calculated master measurement cycle is greater than the set value, management device 10 sets the calculated master measurement cycle as the new set value. Management device 10 also sets the calculated master measurement cycle as the new set value when the calculated master measurement cycle is equal to or less than the set value. Note that the present disclosure is not limited to this example, and when the calculated master measurement cycle is equal to or less than the set value, management device 10 may maintain the preset set value.

In this manner, in the master measurement cycle setting process, the master measurement cycle is set in accordance with the number of monitoring devices 20 connected to management device 10 and the voltage acquisition cycle. Therefore, even when the number of monitoring devices 20 connected to management device 10 changes, management device 10 can acquire battery information related to secondary batteries within an appropriate time.

### (Cycle Setting Process)

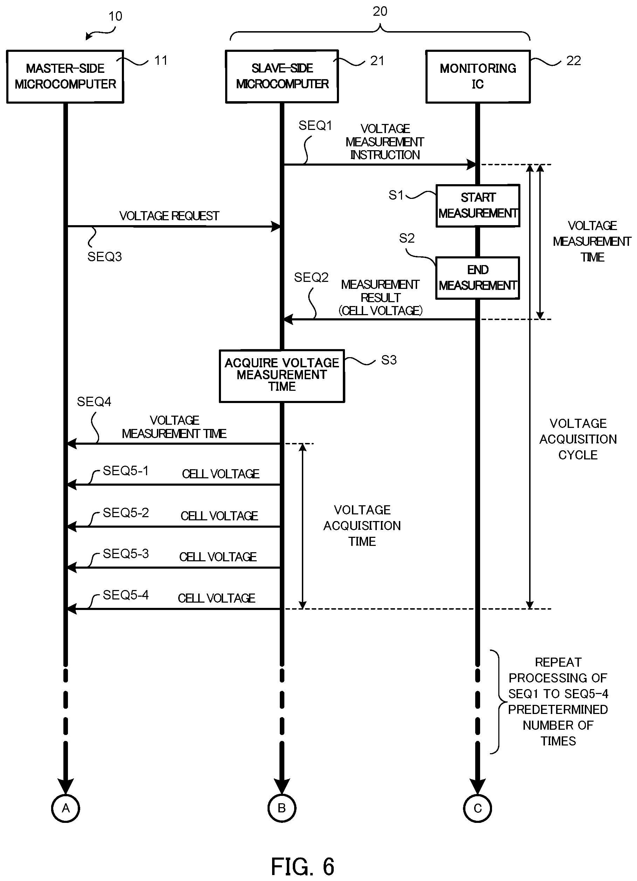

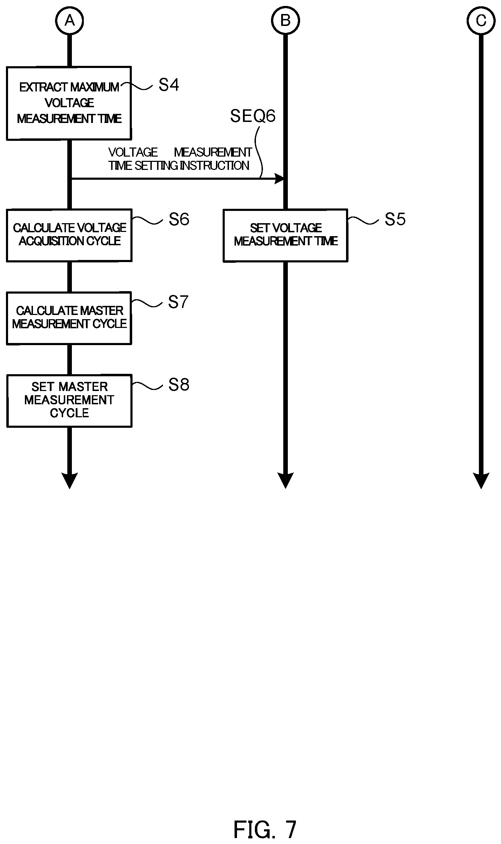

FIGS. 6 and 7 are sequence diagrams illustrating an example of the flow of the cycle setting process performed by battery management system 1 according to the present embodiment. Note that this example illustrates the process performed between management device 10 and a predetermined one of the plurality of monitoring devices 20 connected to management device 10. In the actual cycle setting process, it is assumed that management device 10 performs the same process with other monitoring devices 20 not shown in the diagrams. In FIGS. 6 and 7, symbols A to C indicate that the process transitions to the corresponding symbol.

First, when the voltage acquisition cycle elapses, slave-side microcomputer 21 of monitoring device 20 transmits a voltage measurement instruction to monitoring IC 22 (Sequence SEQ1).

Upon receiving the voltage measurement instruction, monitoring IC 22 starts measuring the cell voltage of secondary battery 30 connected to monitoring device 20 in Step S1. When the cell voltages of all battery cells constituting secondary battery 30 have been measured, monitoring IC 22 ends the measurement of the cell voltages of secondary battery 30 in Step S2. Monitoring IC 22 then transmits the cell voltages of all battery cells, which are the measurement results, to slave-side microcomputer 21 (Sequence SEQ2).

Upon receiving the cell voltage, slave-side microcomputer 21 acquires the voltage measurement time in Step S3. The voltage measurement time at this point is the elapsed time from when the voltage measurement instruction is transmitted to monitoring IC 22 in Sequence SEQ1 to when the cell voltage is received from monitoring IC 22.

Meanwhile, master-side microcomputer 11 transmits a voltage request to slave-side microcomputer 21 for receiving the cell voltage (Sequence SEQ3).

Upon receiving the voltage request from master-side microcomputer 11, slave-side microcomputer 21 transmits the voltage measurement time acquired in Step S3 to master-side microcomputer 11 (Sequence SEQ4).

Slave-side microcomputer 21 also transmits the cell voltage acquired from monitoring IC 22 to master-side microcomputer 11 in accordance with the voltage request from master-side microcomputer 11 (Sequences SEQ5-1 to SEQ5-4).

Here, for example, when CAN is used as the communication protocol, the number of frames and the data size that can be handled in a single transmission and reception are fixed in CAN. Therefore, when the data size of all cell voltages exceeds the prescribed size, it is necessary to divide the cell voltage data and transmit the data using multiple frames. In this example, slave-side microcomputer 21 divides all cell voltage data into four portions and transmits the cell voltage data to master-side microcomputer 11 in four separate transmissions.

Note that the transmission and reception of cell voltages is not limited to this example. For example, when the data size that can be handled in a single transmission and reception is larger than the data size of all cell voltages, slave-side microcomputer 21 may transmit all cell voltages to master-side microcomputer 11 at once. That is, slave-side microcomputer 21 only needs to transmit the cell voltages as defined by the communication protocol used between management device 10 and monitoring device 20.

In this cycle setting process, the processing from Sequences SEQ1 to SEQ5-4 is repeated a predetermined number of times, such as five times. This is to suppress errors due to variations in the voltage measurement time in the process of Step S4 described later.

Next, upon receiving the voltage measurement times and cell voltages from all monitoring devices 20, master-side microcomputer 11 extracts the maximum voltage measurement time from among the received voltage measurement times in Step S4. Master-side microcomputer 11 then transmits to slave-side microcomputer 21 a voltage measurement time setting instruction for setting the extracted maximum voltage measurement time as the voltage measurement time, along with the maximum voltage measurement time (Sequence SEQ6).

Upon receiving the voltage measurement time setting instruction, slave-side microcomputer 21 sets the received maximum voltage measurement time as the voltage measurement time in Step S5.

Furthermore, in Step S6, master-side microcomputer 11 calculates the voltage acquisition cycle by adding the voltage measurement time and the voltage acquisition time together. The voltage measurement time used here is the maximum voltage measurement time extracted in Step S4. The voltage acquisition time is the time required to receive the voltage measurement time and the cell voltage from slave-side microcomputer 21. Specifically, the voltage acquisition time is the time from when the voltage measurement time is received in Sequence SEQ4 to when the cell voltage is received in Sequence SEQ5-4.

Next, in Step S7, master-side microcomputer 11 calculates the master measurement cycle by multiplying the voltage acquisition cycle calculated in Step S6 by the number of monitoring devices 20 connected to management device 10.

Then, in Step S8, master-side microcomputer 11 compares the calculated master measurement cycle with the current set value of the preset master measurement cycle, and sets the master measurement cycle based on the result of the comparison. For example, when the calculated master measurement cycle is greater than the set value, master-side microcomputer 11 sets the calculated master measurement cycle as the new set value. Master-side microcomputer 11 also sets the calculated master measurement cycle as the new set value when the calculated master measurement cycle is equal to or less than the set value. Note that the present disclosure is not limited to this example, and when the calculated master measurement cycle is equal to or less than the set value, management device 10 may maintain the preset set value.

As described above, in BMS 1 according to the present embodiment, management device 10, which manages a plurality of monitoring devices 20, acquires, from each monitoring device 20, the voltage measurement time indicating the time required to measure the voltage of secondary battery 30. Management device 10 then unifies the voltage measurement time of each monitoring device based on the acquired voltage measurement times. As a result, in BMS 1, the voltage measurement time can be automatically set even when the number of monitoring devices 20 connected to management device 10 changes.

### [Variation]

A battery management system according to a variation of the present embodiment will be described. In BMS 1 described above, it is assumed that management device 10, monitoring device 20, and secondary battery 30 are arranged in a common apparatus. In contrast, for example, management device 10 may be configured separately from monitoring device 20 and secondary battery 30, and may remotely control and manage monitoring device 20 and secondary battery 30.

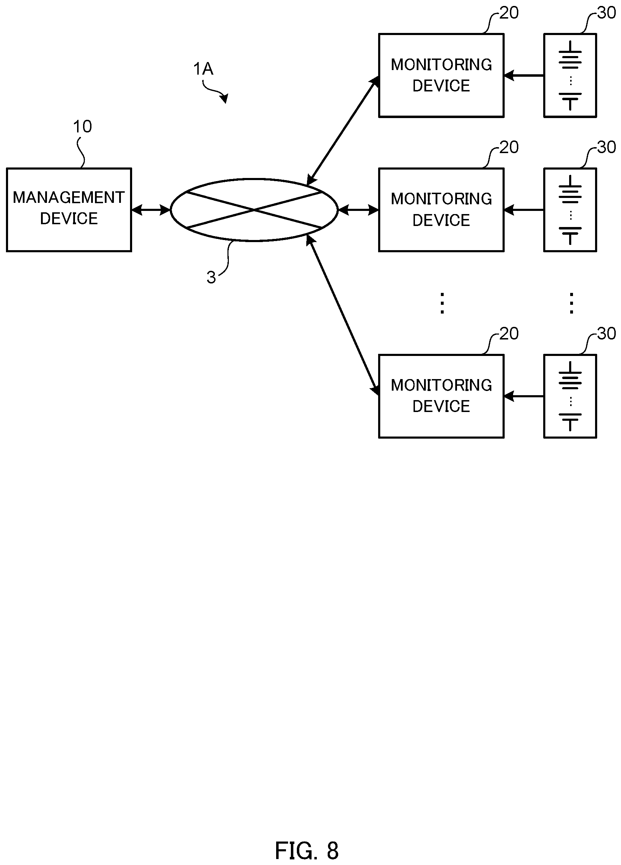

FIG. 8 is a schematic diagram illustrating an example of the configuration of battery management system 1A according to a variation of the present embodiment. As illustrated in FIG. 8, BMS 1A includes management device 10 serving as a master device, a plurality of monitoring devices 20 serving as slave devices, and a plurality of secondary batteries 30. In this variation, management device 10 is connected to the plurality of monitoring devices 20 via network 3 such as the Internet or an intranet.

In BMS 1A having the configuration illustrated in FIG. 8 as well, various types of information can be exchanged between management device 10 and monitoring devices 20 via network 3. Therefore, management device 10 can perform the cycle setting process described above with the plurality of monitoring devices 20 connected via network 3.

The disclosure of Japanese Patent Application No. 2023-203101, filed on November 30, 2023, including the specification, drawings and abstract, is incorporated herein by reference in its entirety.

### Reference Signs List

1, 1A Battery management system
2 Bus
3 Network
10 Management device
11 Master-side microcomputer
20, 20A, 20B, 20C, 20D, 20E, 20F, 20G Monitoring device
21 Slave-side microcomputer
22 Monitoring IC
30 Secondary battery

## Claims

1. A battery management system, comprising:
a plurality of monitoring devices that each measure a voltage of corresponding one of a plurality of secondary batteries; and
a management device that manages the plurality of monitoring devices, wherein
the management device acquires, from each of the plurality of monitoring devices, a voltage measurement time indicating a time required to measure the voltage of corresponding one of the plurality of secondary batteries, and
the management device unifies the voltage measurement time of each of the plurality of monitoring devices based on a plurality of the acquired voltage measurement times.

2. The battery management system according to claim 1, wherein
the management device extracts a maximum value from the plurality of the voltage measurement times received from the plurality of monitoring devices, and
the management device sets the extracted maximum value as a new voltage measurement time in each of the plurality of monitoring devices.

3. The battery management system according to claim 2, wherein
the plurality of monitoring devices each measure the voltage measurement time a predetermined number of times, and
the management device extracts a voltage measurement time having a maximum value from among a plurality of the voltage measurement times measured by each of the plurality of the monitoring devices.

4. The battery management system according to claim 2, wherein
the management device calculates a voltage acquisition cycle based on the new voltage measurement time set in all the plurality of monitoring devices and a voltage acquisition time for each of the plurality of monitoring devices, and
the management device determines a master measurement cycle based on the voltage acquisition cycle.

5. The battery management system according to claim 1, wherein
the plurality of monitoring devices each include a monitoring IC that measures a voltage of corresponding one of the plurality of secondary batteries during the voltage measurement time.

6. A management device for managing a plurality of monitoring devices that each measure a voltage of corresponding one of a plurality of secondary batteries, the management device comprising:
a processing unit that acquires, from each of the plurality of monitoring devices, a voltage measurement time indicating a time required for measuring the voltage of corresponding one of the plurality of secondary batteries, and unifies the voltage measurement time of each of the plurality of monitoring devices based on a plurality of the acquired voltage measurement times.

7. A cycle setting method for a battery management system that includes: a plurality of secondary batteries; a plurality of monitoring devices each measuring a voltage of corresponding one of the plurality of secondary batteries; and a management device for managing the plurality of monitoring devices, the cycle setting method comprising:
acquiring, from each of the plurality of monitoring devices, a voltage measurement time indicating a time required for measuring the voltage of corresponding one of the plurality of secondary batteries; and
unifying the voltage measurement time of each of the plurality of monitoring devices based on a plurality of the acquired voltage measurement times.

8. A program causing a computer to execute the cycle setting method according to claim 7.
